# EUROPÄISCHE PATENTSCHRIFT

(11) **EP 1 648 034 B1**
(45) Veröffentlichungstag und Bekanntmachung des Hinweises auf die Patenterteilung: **30.12.2009**
(21) Anmeldenummer: 05020190.4
(22) Anmeldetag: 16.09.2005
(51) Int. Cl.: H01L 31/0216, C01G 35/00, C23C 14/34

(54) **Aufdampfmaterial, enthaltend Ta2Ox mit x = 4.81 bis 4.88, zur Herstellung hochbrechender Schichten**
Evaporation material comprising Ta2Ox with x = 4.81 bis 4.88, for the deposition of layers with high refraction
Matériau à vaporisation, comprenant Ta2Ox avec x = 4.81 à 4.88, pour déposer des couches avec réfraction élevée

(30) Priorität: 14.10.2004 DE 102004049996
(43) Veröffentlichungstag der Anmeldung: 19.04.2006
(73) Patentinhaber: Merck Patent GmbH, 64293 Darmstadt (DE)
(72) Erfinder: Friz, Martin, Dr., 64297 Darmstadt (DE); Anthes, Uwe, 64711 Erbach (DE); Dombrowski, Reiner, 64739 Höchst (DE)

(56) Entgegenhaltungen:
- WO-A-2004/067463
- US-A- 4 156 622
- PATENT ABSTRACTS OF JAPAN Bd. 017, Nr. 167 (C-1043), 31. März 1993 (1993-03-31) & JP 04 325669 A (CANON INC; others: 01), 16. November 1992 (1992-11-16)
- JEHN H; OLZI E: "High temperature solid-solubility limit and phase studies in the system tantalum-oxygen" JOURNAL OF THE LESS-COMMON METALS, Bd. 27, Nr. 3, Juni 1972 (1972-06), Seiten 297-309, Elsevier Sequoia S.A., Lausanne, [CH]

## Beschreibung

Die vorliegende Erfindung betrifft die Verwendung von Aufdampfmaterialien bestehend aus Ta₂Oₓ mit x = 4.81 bis 4.88 zur Herstellung hochbrechender Schichten und ein Verfahren zur Herstellung von hochbrechenden Schichten.

Zum Schutz der Oberflächen oder zur Erzielung bestimmter optischer Eigenschaften werden optische Bauteile üblicherweise mit dünnen Beschichtungen versehen. Bei derartigen optischen Bauteilen handelt es sich beispielsweise um optische Linsen, Brillengläser, Objektive für Kameras, Ferngläser oder für andere optische Geräte, um Strahlteiler, Prismen, Spiegel, Fensterscheiben und dergleichen. Die Beschichtungen dienen dabei einerseits zur Vergütung der genannten Oberflächen durch Härtung und/oder Erhöhung der chemischen Resistenz um Schädigungen durch mechanische, chemische oder Umwelteinflüsse zu vermindern oder zu vermeiden, andererseits aber oft auch zur Erzielung einer verminderten Reflexion, was insbesondere bei Brillengläsern und Objektiven der Fall ist.

In diesem Zusammenhang ist Tantal(V)-oxid (Ta₂O₅) ein bekanntes und häufig eingesetztes Material zur Herstellung hochbrechender Schichten. Üblicherweise erfolgt die Aufbringung von Ta₂O₅-Schichten durch Verdampfen im Vakuum. Hierbei wird zunächst das zu beschichtende Substrat und eine Ta₂O₅ enthaltende Vorlage in einer geeigneten Hochvakuumaufdampfapparatur platziert, anschließend die Apparatur evakuiert und die Aufdampfsubstanz durch Erhitzen und/oder Elektronenstrahlbeschuss zur Verdampfung gebracht, wobei sich das Aufdampfmaterial als dünne Schicht auf der Substratoberfläche niederschlägt. Entsprechende Apparaturen und Verfahren sind gängiger Stand der Technik.

Ta₂O₅ hat in den oben genannten Verfahren den Nachteil, dass es beim Einschmelzen und Verdampfen größere Mengen Sauerstoff freisetzt. Dies erfolgt in der Regel so lange, bis eine Zusammensetzung der Formel Ta₂O₅₋ₓ mit x = 0.2 bis 0.4 erreicht ist. Die genaue Zusammensetzung hängt maßgeblich von der Temperatur der Substanz während der Verdampfung ab. Durch die Freisetzung von Sauerstoff ergibt sich in den Aufdampfanlagen eine Druckerhöhung, die je nach den Bedingungen sehr groß sein kann und bis zum Abbruch der Verdampfung führen kann.

Um diesen Druckanstieg während der Verdampfung zu vermeiden, wird Ta₂O₅ meist in einem vorgelagerten Verfahrensschritt vorgeschmolzen. Dazu legt man eine gewisse Menge Ta₂O₅ in einem Behältnis vor, schmilzt das Ta₂O₅ im Vakuum ein und lässt die Schmelze abkühlen. Anschließend wird erneut Ta₂O₅ in den Behälter gegeben, um dieses mit den oben genannten Verfahrensschritten ebenfalls vorzuschmelzen. Dieser Vorgang wird so lange wiederholt, bis die für den Verdampfungsprozess benötigte Menge an geschmolzenem Material erhalten wurde. Je nach Schmelztemperatur und Dauer des Schmelzvorgangs weist das erhaltene Aufdampfmaterial eine Zusammensetzung von Ta₂O_{4.6} bis Ta₂O_{4.8} auf. Das Vorschmelzen ist ein kostenintensiver und langwieriger Prozess und damit für die Bereitstellung größerer Mengen an Aufdampfmaterial nicht geeignet.

Aus US 4,156,622 ist bekannt, dass durch Elektronenstrahlverdampfung einer Mischung aus Ta₂O₅ und elementarem Tantal auf Solarzellen Tantalsuboxide der Formel Ta₂O_{y} mit y = 2.5 bis 4.8, vorzugsweise mit y = 3.3 bis 4.5, erhalten werden können. Die oben genannte Methode erweist sich aber als nachteilig, wenn möglichst Schichten homogener Zusammensetzung erhalten werden sollen, da lokale Inhomogenitäten bei der Mischung zur Abscheidung von Tantalsuboxiden unterschiedlicher Zusammensetzung führen. Die gezielte Steuerung der Schichtzusammensetzung ist damit mit der oben genannten Methode nicht erreichbar.

JP 04-325669 beschreibt eine gesinterte Mischung aus Ta₂O₅ und Ta, wobei der Anteil an Ta zwischen 4 und 55 Gew.-% beträgt. Dies entspricht Tantalsuboxiden mit der Formel Ta₂O₂ bis Ta₂O_{4 76}. Die erhaltenen Tantalsuboxide werden mittels Elektronenstrahlverdampfung verdampft und auf einem Substrat aufgebracht. Aus JP 62-207937 sind gesinterte Ta₂O₅/Ta-Mischungen bekannt, wobei das Verhältnis von Ta₂O₅ zu Ta 9:1 beträgt. Dies entspricht einer Zusammensetzung gemäß der Formel Ta₂O_{4.73}.

Der Einsatz von Tantalsuboxiden der oben genannten Zusammensetzungen erweist sich aber als nachteilig, weil die damit aufgedampften Schichten vielfach Absorption im sichtbaren Bereich des Spektrums zeigen. Dieser Effekt ist unerwünscht und lässt sich auch nur durch nachträgliches Erhitzen der Beschichtung an Luft bei Temperaturen um 400°C beseitigen. Dies bedeutet die Notwendigkeit eines weiteren Prozessschrittes, der energetisch ungünstig ist und der darüber hinaus den Herstellungsprozess der gewünschten Schichten verlängert. Eine andere Möglichkeit die Bildung absorbierender Schichten zu vermeiden ist der Einsatz von lonen- oder Plasma-gestützten Aufdampfprozessen, die die Bildung von ionisiertem Sauerstoff beinhalten. Diese speziellen Prozesse und die dafür nötigen Apparaturen sind sehr aufwendig und kostspielig und bedürfen einer genauen Prozesskontrolle, um das gewünschte Ergebnis zu erzielen. Für den großtechnischen Einsatz sind diese Prozesse damit ungeeignet.

Intensive Untersuchungen haben ergeben, dass durch Erhöhung des Sauerstoffanteils im Aufdampfmaterial die Bildung nichtabsorbierender Schichten begünstigt wird. Demgegenüber führt ein zu hoher Sauerstoffanteil zu dem vorab beschriebenen unerwünschten Druckanstieg. Es bestand daher die Aufgabe, Aufdampfmaterialien bereit zu stellen, die dieses Paradoxon zu überwinden vermögen, ohne dass der eigentliche Verdampfungsprozess modifiziert werden muss.

Anwendung der erfindungsgemäßen Aufdampfmaterialien daher keinerlei Beschränkungen unterworfen, sofern die Substrate in die Vakuumapparatur eingebracht werden können und bei den herrschenden Temperatur- und Druckverhältnissen stabil bleiben. Es hat sich jedoch als vorteilhaft herausgestellt, die Substrate zur Erhöhung der Dichte der aufgebrachten Schichten vor und während des Beschichtens zu erwärmen, so dass das Aufdampfmaterial auf ein vorgeheiztes Substrat trifft. Je nach Art der eingesetzten Substrate wird dabei auf Temperaturen bis 300°C erwärmt. Diese Maßnahme an sich ist jedoch bekannt.

Als Aufdampfverfahren wird üblicherweise ein Hochvakuumaufdampfverfahren eingesetzt, bei welchem das Aufdampfmaterial in einer geeigneten Vorlage, welche auch als Verdampfungstiegel oder-schiffchen bezeichnet wird, zusammen mit dem zu beschichtenden Substrat in eine Vakuumapparatur eingebracht wird.

Anschließend wird die Apparatur evakuiert und das Aufdampfmaterial durch Erhitzen und/oder Elektronenstrahlbeschuss zur Verdampfung gebracht. Dabei schlägt sich das Aufdampfmaterial als dünne Schicht auf dem Substrat nieder.

Der Einsatz aufwendiger Methoden bei der Beschichtung, z.B. der lonenbeschuss (Ion Assisted Deposition, Plasma Assisted Deposition), ist bei Verwendung der erfindungsgemäßen Aufdampfmaterialien nicht erforderlich. Dies verringert den apparativen Aufwand und verringert damit die Kosten für die Beschichtung, bei gleichzeitiger Qualität der erhaltenen hochbrechenden Schichten.

Die nachfolgenden Beispiele sollen die Erfindung näher erläutern, ohne sie jedoch zu begrenzen.

### Beispiele

### Beispiel 1: Herstellung des Aufdampfmaterials

97 Gewichtsprozent Tantaloxid (Ta₂O₅) und 3 Gewichtsprozent Tantal-Metall-Pulver werden unter Zusatz von Wasser in einer Kugelmühle intensiv gemischt. Anschließend wird das Gemisch getrocknet und zu Körnern mit einer Korngröße von 1 bis 4 mm verarbeitet. Die Körner werden in einem Hochtemperatur-Vakuumofen im Vakuum bei einem Druck unter 10 mPa (1x10⁻⁴ mbar) mit einer Aufheizgeschwindigkeit von 1 K/min auf 1650°C erhitzt und 32 Stunden bei dieser Temperatur gehalten. Anschließend wird das Material mit 5 K/min abgekühlt. Nach Abkühlen auf 25°C wird der Vakuumofen mit Luft geflutet und das Material wird entnommen. Das erhaltene Aufdampfmaterial besteht aus harten, tiefschwarzen Körnern mit der Zusammensetzung Ta₂O_{4.82}.

### Beispiel 2: Verwendung des Aufdampfmaterials zu Herstellung hochbrechender Schichten

Eine handelsübliche Aufdampfanlage (L560 von Fa. Leybold) wird mit gereinigten Substraten aus Quarzglas bestückt. Das Aufdampfmaterial aus Beispiel 1 wird in den wassergekühlten Kupfertiegel einer Elektronenstrahlverdampfereinrichtung gefüllt. Die Aufdampfanlage wird bis zu einem Druck von 1 mPa (1x10⁻⁵ mbar) evakuiert. Dann wird die Substratheizung auf 200°C eingestellt. Nach 1 Stunde ist eine gleichmäßige Substrattemperatur von etwa 160°C erreicht. Anschließend wird mit einem Regulierventil Sauerstoff in die Anlage eingelassen bis sich ein Druck von 20 mPa (2x10⁻⁴ mbar) einstellt. Das Aufdampfmaterial wird dann unter einer Blende eingeschmolzen und auf die Verdampfungstemperatur erhitzt. Beim Einschmelzen und Verdampfen tritt kein Druckanstieg und kein Spritzen durch Schmelztröpfchen auf. Dann wird die Blende geöffnet. Mit einem Schwingquarzschichtdickenmessgerät wird die Aufdampfrate auf 0.2 nm/s eingeregelt. Anschließend wird die Substanz mit dieser Aufdampfrate verdampft bis eine Schichtdicke von 230 nm erreicht ist. Die Verdampfung wird danach beendet.

Die mit dem Aufdampfmaterial aufgebrachte Schicht hat einen Brechungsindex von 2.05 bei 500 nm. Die Schicht ist homogen, das heißt der Brechungsindex ist über die gesamte Schichtdicke konstant. Die Schicht ist im sichtbaren Spektralbereich bei Wellenlängen über 350 nm absorptionsfrei. Die Absorption steigt erst bei etwa 300 nm steil zum ultravioletten Spektralbereich hin an.

Die vorliegende Aufgabe wird durch die Verwendung von Aufdampfmaterialien gemäß der vorliegenden Erfindung in erfinderischer Weise erfüllt. Gegenstand der vorliegenden Erfindung ist demgemäss die Verwendung von Aufdampfmaterialien bestehend aus Ta₂Oₓ mit x = 4.81 bis 4.88 zur Herstellung von hochbrechenden Schichten.

Weiterer Gegenstand der vorliegenden Erfindung ist ein Verfahren gemäß Anspruch 6 zur Herstellung hochbrechender Schichten umfassend das Herstellen von Aufdampfmaterialien bestehend aus Ta₂Oₓ mit x = 4.81 bis 4.88, durch Mischen von Ta₂O₅ mit 1.9 bis 3.1 Gew.-% Ta, bezogen auf die Mischung, Komprimieren oder Suspendieren, Formen und anschließendes Sintern der Mischung im Vakuum.

Die erfindungsgemäßen Aufdampfmaterialien sind in vielerlei Hinsicht vorteilhaft. So zeigen die für die Herstellung der Aufdampfmaterialien eingesetzten Mischungen aus Ta₂O₅ und Ta ein sehr gutes Verhalten beim Einschmelzen, in dessen Verlauf eine homogene und kompakte Schmelze entsteht. Dies ist besonders wichtig, um eine homogene Beschichtung ohne Schwankungen bei der Zusammensetzung der Beschichtung erreichen zu können. Bei Einsatz der erfindungsgemäßen Aufdampfmaterialien unter Verwendung der Elektronenstrahlverdampfung werden absorptionsfreie Schichten erhalten, ohne dass eine zusätzliche Nachbehandlung nötig wäre. Gleichzeitig ist nur ein geringer Anstieg des Druckes bei Verdampfung des Aufdampfmaterials zu beobachten, das heißt, es wird nur eine geringe Menge an Sauerstoff freigesetzt und die Kontrolle und Einhaltung der gewünschten Prozessparameter wird erleichtert und verbessert. Das spezielle Verhältnis von Tantal zu Sauerstoff in den erfindungsgemäßen Aufdampfmaterialien macht die Kombination der genannten Vorteile erst möglich und ist damit erfindungswesentlich.

Die erfindungsgemäßen Aufdampfmaterialien enthalten Ta₂Oₓ mit x = 4.81 bis 4.88, vorzugsweise enthalten die Aufdampfmaterialien Ta₂O_{4.82}. Letzteres ist erhältlich durch Mischen von Pa₂O₅ mit 3 Gew.-% Ta, bezogen auf die Mischung, Komprimieren oder Suspendieren, Formen und anschließendes Sintern der Mischung im Vakuum. In überraschender Weise hat sich gezeigt, dass Aufdampfmaterialien dieser Zusammensetzung ganz besonders geeignet sind, daraus hochbrechende nichtabsorbierende Schichten herzustellen.

Bei dem erfindungsgemäßen Verfahrensschritt a) zur Herstellung der oben beschriebenen Aufdampfmaterialien wird Ta₂O₅ mit 1.9 bis 3.1 Gew.-% Ta, bezogen auf die Mischung, gemischt, die Mischung wird komprimiert oder suspendiert, geformt und anschließend im Vakuum gesintert. Zur Herstellung der bevorzugten Ausführungsform enthaltend Ta₂O_{4.82} wird Ta₂O₅ mit 3 Gew.-% Ta, bezogen auf die Mischung, gemischt, die Mischung wird komprimiert oder suspendiert, geformt und anschließend im Vakuum gesintert.

Das oben genannte Gemisch aus Ta₂O₅ und Ta wird mittels geeigneter, an sich bekannter Maßnahmen der Komprimierung verdichtet und geformt. Es kann jedoch auch eine Suspension der gemischten Komponenten in einem geeigneten Trägermedium hergestellt werden, welche geformt und anschließend getrocknet wird. Ein geeignetes Trägermedium ist beispielsweise Wasser, welchem je nach Bedarf Bindemittel wie Polyvinylalkohol, Methylzellulose oder Polyethylenglykol sowie gegebenenfalls Hilfsmittel, wie z.B. Netzmittel oder Entschäumer, zugesetzt werden. Nach dem Suspendieren erfolgt eine Formgebung. Hierbei können verschiedene bekannte Techniken, wie Strangpressen, Spritzgießen oder auch Sprühtrocknen Anwendung finden. Die erhaltenen Formen werden getrocknet und vom Bindemittel, beispielsweise durch Ausbrennen, befreit. Dies erfolgt aus Gründen einer besseren Handhabbarkeit und Dosierbarkeit der Mischungen. Daher sind die Formen, in welche das Gemisch gebracht wird, nicht limitiert. Geeignet sind alle Formen, welche eine einfache Handhabung und eine gute Dosierbarkeit ermöglichen, die insbesondere bei der kontinuierlichen Beschichtung von Substraten mit dem erfindungsgemäßen Aufdampfmaterial und dem dafür nötigen Nachfüllprozess eine besondere Rolle spielen. Bevorzugte Formen sind daher verschiedene Tablettenformen, Pellets, Scheiben, Kegelstümpfe, Körner bzw. Granulate, Stangen oder auch Kugeln.

Anschließend werden die geformten Gemische gesintert. Der Sinterprozess erfolgt im Vakuum bei Temperaturen von 1300 bis 1800°C und einem Restdruck von unter 1 Pa, vorzugsweise bei Temperaturen von 1400 bis 1700°C.

Die entstehenden geformten Sinterprodukte bleiben in ihrer Form beim Lagern, Transportieren und beim Einfüllen in die Verdampfungsapparatur bestehen und sind in ihrer Zusammensetzung während des gesamten nachfolgenden Aufschmelz- und Verdampfungsprozesses stabil. '

Bei der erfindungsgemäßen Verwendung der Aufdampfmaterialien zur Herstellung von hochbrechenden Schichten, lassen sich alle geeigneten Substrate mit dem erfindungsgemäßen Aufdampfmaterial beschichten, insbesondere Scheiben, Prismen, Folien, geformte Substrate wie optische Linsen, Brillengläser und Objektive und dergleichen, welche aus den bekannten geeigneten Materialien wie verschiedenen Gläsern oder Kunststoffen bestehen können. Bezüglich Art, Größe, Form, Material und Oberflächenbeschaffenheit der zu beschichtenden Substrate ist die

## Patentansprüche

1. Verwendung von Aufdampfmaterialien bestehend aus Ta₂Oₓ mit x = 4.81 bis 4.88 zur Herstellung von hochbrechenden Schichten.

2. Verwendung gemäß Anspruch 1, **dadurch gekennzeichnet, dass** die Aufdampfmaterialien aus Ta₂O_{4.82} bestehen.

3. Verwendung gemäß einem oder mehreren der Ansprüche 1 bis 2, **dadurch gekennzeichnet, dass** die Aufdampfmaterialien durch Mischen von Ta₂O₅ mit 1.9 bis 3.1 Gew.-% Ta, bezogen auf die Mischung, Komprimieren oder Suspendieren, Formen und anschließendes Sintern der Mischung im Vakuum erhältlich sind.

4. Verwendung gemäß einem oder mehreren der Ansprüche 1 bis 3, **dadurch gekennzeichnet, dass** die Aufdampfmaterialien durch Mischen von Ta₂O₅ mit 3 Gew.-% Ta, bezogen auf die Mischung, erhältlich sind.

5. Verwendung gemäß einem oder mehreren der Ansprüche 1 bis 4, **dadurch gekennzeichnet, dass** die Aufdampfmaterialien in Form von Tabletten, Pellets, Scheiben, Kegelstümpfen, Körnern, Granulaten, Stangen oder Kugeln vorliegen.

6. Verfahren zur Herstellung von hochbrechenden Schichten, umfassend
(a) das Herstellen von Aufdampfmaterialien bestehend aus Ta₂Oₓ mit x = 4.81 bis 4.88 durch Mischen von Ta₂O₅ mit 1.9 bis 3.1 Gew.-% Ta, bezogen auf die Mischung, Komprimieren oder Suspendieren, Formen und anschließendes Sintern der Mischung im Vakuum,
(b) das Einbringen der unter (a) hergestellten Aufdampfmaterialien in eine mit einem zu beschichtenden Substrat bestückte Vakuumapparatur,
(c) das Evakuieren der Vakuumapparatur,
(d) das Verdampfen der Aufdampfmaterialien durch Erhitzen und/oder Elektronenstrahlbeschuss, wobei sich das Aufdampfmaterial auf dem Substrat niederschlägt.

7. Verfahren gemäß Anspruch 6, **dadurch gekennzeichnet, dass** Ta₂O₅ mit 3 Gew.-% Ta, bezogen auf die Mischung, gemischt wird, die Mischung komprimiert oder suspendiert, geformt und anschließend im Vakuum gesintert wird.

8. Verfahren gemäß einem oder mehreren der Ansprüche 6 bis 7, **dadurch gekennzeichnet, dass** das Substrat vor und/oder während des Beschichtens erwärmt wird.

9. Verfahren gemäß einem oder mehreren der Ansprüche 6 bis 8, **dadurch gekennzeichnet, dass** als Substrate Scheiben, Prismen, Folien, optische Linsen Brillengäser oder Objektive verwendet werden.

10. Verfahren gemäß einem oder mehreren der Ansprüche 6 bis 9, **dadurch gekennzeichnet, dass** Substrate bestehend aus verschiedenen Gläsern oder Kunststoffen verwendet werden.

11. Verfahren gemäß einem oder mehreren der Ansprüche 6 bis 10, **dadurch gekennzeichnet, dass** das Mischen von Ta₂O₅ mit Ta unter Zusatz eines Trägermediums und/oder Binde- bzw- Hilfsmitteln erfolgt und das Trägermedium und die Binde- bzw- Hilfsmittel nach dem Formen entfernt werden.

## Claims

1. Use of vapour-deposition materials consisting of Ta₂Oₓ, where x = 4.81 to 4.88, for the production of highly refractive layers.

2. Use according to Claim 1, **characterised in that** the vapour-deposition materials consist of Ta₂O_{4.82}.

3. Use according to one or more of Claims 1 to 2, **characterised in that** the vapour-deposition materials are obtainable by mixing Ta₂O₅ with 1.9 to 3.1 % by weight of Ta, based on the mixture, compressing or suspending, shaping and subsequently sintering the mixture in vacuo.

4. Use according to one or more of Claims 1 to 3, **characterised in that** the vapour-deposition materials are obtainable by mixing Ta₂O₅ with 3% by weight of Ta, based on the mixture.

5. Use according to one or more of Claims 1 to 4, **characterised in that** the vapour-deposition materials are in the form of tablets, pellets, discs, truncated cones, grains, granules, rods or spheres.

6. Process for the production of highly refractive layers, comprising
(a) the preparation of vapour-deposition materials consisting of Ta₂Oₓ, where x = 4.81 to 4.88, by mixing Ta₂O₅ with 1.9 to 3.1% by weight of Ta, based on the mixture, compressing or suspending, shaping and subsequently sintering the mixture in vacuo,
(b) the introduction of the vapour-deposition materials prepared under
(a) into a vacuum apparatus fitted with a substrate to be coated,
(c) the evacuation of the vacuum apparatus,
(d) the evaporation of the vapour-deposition materials by heating and/or electron beam bombardment, during which the vapour-deposition material precipitates on the substrate.

7. Process according to Claim 6, **characterised in that** Ta₂Oₛ is mixed with 3% by weight of Ta, based on the mixture, the mixture is compressed or suspended, shaped and subsequently sintered in vacuo.

8. Process according to one or more of Claims 6 to 7, **characterised in that** the substrate is warmed before and/or during the coating.

9. Process according to one or more of Claims 6 to 8, **characterised in that** the substrates used are discs, prisms, films, optical lenses, spectacle lenses or objectives.

10. Process according to one or more of Claims 6 to 9, **characterised in that** substrates consisting of different glasses or plastics are used.

11. Process according to one or more of Claims 6 to 10, **characterised in that** the mixing of Ta₂O₅ with Ta is carried out with addition of a carrier medium and/or binders or assistants, and the carrier medium and the binders or assistants are removed after the shaping.

## Revendications

1. Utilisation de matériaux de dépôt en phase vapeur constitués de Ta₂Oₓ, où x = 4,81 à 4,88, pour la production de couches hautement réfractives.

2. Utilisation selon la revendication 1, **caractérisée en ce que** les matériaux de dépôt en phase vapeur sont constitués de Ta₂O_{4,82}.

3. Utilisation selon l'une ou plusieurs des revendications 1 à 2, **caractérisée en ce que** les matériaux de dépôt en phase vapeur peuvent être obtenus par le mélange deTa₂O₅ avec de 1,9 à 3,1 % en poids de Ta, sur la base du mélange, la compression ou la mise en suspension, la mise en forme puis le frittage du mélange sous vide.

4. Utilisation selon l'une ou plusieurs des revendications 1 à 3, **caractérisée en ce que** les matériaux de dépôt en phase vapeur peuvent être obtenus par le mélange de Ta₂O₅ avec 3% en poids de Ta, sur la base du mélange.

5. Utilisation selon l'une ou plusieurs des revendications 1 à 4, **caractérisée en ce que** les matériaux de dépôt en phase vapeur sont sous la forme de comprimés, de pastilles, de disques, de cônes tronqués, de grains, de granulés, de bâtonnets ou de sphères.

6. Procédé de production de couches hautement réfractives, comprenant
(a) la préparation de matériaux de dépôt en phase vapeur constitués de Ta₂Oₓ, où x = 4,81 à 4,88, par le mélange de Ta₂O₅ avec de 1,9 à 3,1% en poids de Ta, sur la base du mélange, la compression ou la mise en suspension, la mise en forme puis le frittage du mélange sous vide,
(b) l'introduction des matériaux de dépôt en phase vapeur préparés en
(a) dans un appareil à vide pourvu d'un substrat à revêtir,
(c) l'évacuation de l'appareil à vide,
(d) l'évaporation des matériaux de dépôt en phase vapeur par chauffage et/ou bombardement électronique, lors duquel ou desquels le matériau de dépôt en phase vapeur précipite sur le substrat.

7. Procédé selon la revendication 6, **caractérisé en ce que** le Ta₂0₅ est mélangé avec 3% en poids de Ta, sur la base du mélange, le mélange est compressé ou mis en suspension, mis en forme puis fritté sous vide.

8. Procédé selon l'une ou plusieurs des revendications 6 à 7, **caractérisé en ce que** le substrat est chauffé avant et/ou pendant le revêtement.

9. Procédé selon l'une ou plusieurs des revendications 6 à 8, **caractérisé en ce que** les substrats utilisés sont des disques, des prismes, des films, des lentilles optiques, des lentilles ophtalmiques ou des objectifs.

10. Procédé selon l'une ou plusieurs des revendications 6 à 9, **caractérisé en ce qu'**on utilise des substrats constitués de différents verres ou plastiques.

11. Procédé selon l'une ou plusieurs des revendications 6 à 10, **caractérisé en ce que** le mélange de Ta₂O₅ avec du Ta est effectué avec l'addition d'un milieu véhicule et/ou des liants ou auxiliaires, et le milieu véhicule et les liants ou auxiliaires sont éliminés après la mise en forme.
